# EUROPEAN PATENT SPECIFICATION

(11) **EP 0 772 237 B1**
(45) Date of publication and mention of the grant of the patent: **04.02.2004**
(21) Application number: 96117504.9
(22) Date of filing: 31.10.1996
(51) Int. Cl.: H01L 27/02

(54) **Semiconductor device including protection means**
Halbleiteranordung mit einem Schutzmittel
Dispositif semi-conducteur comprenant des moyens de protection

(30) Priority: 31.10.1995 US 7194
(43) Date of publication of application: 07.05.1997
(73) Proprietor: TEXAS INSTRUMENTS INCORPORATED, Dallas Texas 75265 (US)
(72) Inventor: Duvvury, Charvaka, Plano, TX 75025 (US); Chaine, Michael D., Missouri City, TX 77459 (US)
(74) Representative: Degwert, Hartmut, Dipl.-Phys.

(56) References cited:
- US-A- 5 290 724
- US-A- 5 416 351
- US-A- 5 455 436
- US-A- 5 623 156
- AMITAVA CHATTERJEE ET AL: "A LOW-VOLTAGE TRIGGERING SCR FOR ON-CHIP ESD PROTECTION AT OUTPUT AND INPUT PADS" 1 January 1991 , IEEE ELECTRON DEVICE LETTERS, VOL. 12, NR. 1, PAGE(S) 21 - 22 XP000162296 * page 21, column 2, paragraph 2; figures 1,2,4 *

## Description

### FIELD OF THE INVENTION

The instant invention pertains to semiconductor devices and more specifically to the ESD protection devices for DRAM inputs and power supplies.

### BACKGROUND OF THE INVENTION

In many circumstances where an electrostatic discharge event may occur, the backside of the substrate which bares a plurality of memory devices (such as DRAMs) is typically not grounded. Due to this lack of grounding of the backside of the substrate, the typical method of using a grounded gate nMOS device is ineffective for protecting the memory circuitry. Typically, the grounded gate nMOS devices is utilized for clamping the ESD transients to a value below the gate oxide breakdown level. However, under these circumstances, this device is not effective for negative ESD events because the substrate is floating, which results in the gate and source of the MOSFET going "high" together thereby causing the MOSFET to breakdown and fail.

Most DRAM circuits use, as mentioned above, large grounded gate nMOS devices which are connected between V_{DD} and V_{SS} so as to provide supply protection. Some DRAM circuits, on the other hand, use a diode as the protection device. Neither an nMOS device (for negative stress) nor a diode, alone (for positive stress), are very effective in protecting a device when ESD stress is applied to the positive power supply terminal. In addition, placing a diode and an nMOS device as two separate discrete protection devices is not optimal because the layout bus resistance makes the combination of the two devices ineffective for negative stress.

From US-A-5 416 351 an ESD protection diode for a CMOS or BiCMOS integrated circuit is known, which is formed by embedding a Zener diode in the drain of a MOS device used as a protection diode. The document further reports that the Zener diode may be formed with the pre-existing process steps of a BiCMOS process, and that it provides a low voltage trigger for avalanche breakdown in the MOS ESD protection diode.

US-A-5-455 436 discloses an ESD protection circuit for CMOS integrated circuits of p-type substrate having a MOS field effect transistor with lightly-doped drain (LDD) and having at least one bonding pad for external connection, which comprises a first n-well having a heavily-doped n+ diffusion and a heavily-doped p+ diffusion connected together and to the bonding pad, a non-LDD NMOS, which does not have a lightly-doped drain, having a drain connected to the first n-well, an n+ source connected to the negative terminal of a power supply with a positive terminal and a negative terminal, a gate connected to the source, and a channel having an effective channel length longer than the channel length of the NMOS with lightly-doped drain, wherein the first n-well and the non-LDD NMOS form a pnpn SCR structure, which turns on when the ESD pulse appeares at the bonding pad, with the p+ diffusion, the n-well, the p-substrate and the n+ source corresponding to the pnpn structure.

In accordance with the instant invention an ESD protection circuit for protecting a circuit from negative stress due to electrostatic discharge is provided, the ESD protection circuit comprising: a substrate of a first conductivity type and having a surface; a lightly doped region of a second conductivity type opposite the first conductivity type and situated in the substrate; a first doped region of the first conductivity type and situated at the surface of the substrate and in the lightly doped region, the first doped region forming the anode of a first diode and a second diode; a first source region of the second conductivity type and situated at the surface of the substrate and spaced away from the lightly doped region; a first drain region of the second conductivity type and situated at the surface of the substrate, spaced away from the first source region by a first channel region, and abutting the lightly doped region, the first drain region forming the cathode of the first diode; a first gate insulatively disposed over the first channel region, the first source region, first drain region and the first gate forming a first transistor; a second source region of the second conductivity type and situated at the surface of the substrate and spaced away from the lightly doped region; a second drain region of the second conductivity type and situated at the surface of the substrate, spaced away from the second source region by a second channel region, and abutting the lightly doped region, the second drain region forming the cathode of the second diode; a second gate insulatively disposed over the second channel region, the second source region, second drain region and the second gate forming a second transistor whereby the lightly doped region is situated between the first and the second transistor; characterized in that the first source region, the first gate, the second source region, the second gate, and the first doped region are electrically connected and the first and second drain regions are electrically connected together, so that the first and second diodes protect the first and second transistors and the circuit to be protected during the negative stress due to electrostatic discharge.

### BRIEF DESCRIPTION OF THE DRAWINGS

Embodiments of the invention are described, by way of example only, with reference to the accompanying drawings, in which:
FIGURE 1 is a block diagram of an ESD protection circuit.
FIGURE 1a is an I-V curve illustrating the ESD current versus voltage for the ESD protection device of FIGURE 1.
FIGURE 2 is a cross-sectional view of the ESD protection device of the instant invention.
FIGURE 2a is a schematic diagram illustrating the equivalent circuit of the ESD protection device of FIGURE 2.
FIGURE 2b is an I-V curve illustrating the ESD current versus voltage for the ESD protection device of FIGURE 2.
FIGURE 3 is a cross-sectional view of an ESD protection device which is not part of the instant invention.
FIGURE 3a is a schematic diagram illustrating the equivalent circuit of the ESD protection device of FIGURE 3.
FIGURE 4 is a cross-sectional view of an ESD protection device for grounded substrate technologies which is not part of the instant invention.
FIGURE 4a is a schematic diagram illustrating the equivalent circuit of the ESD protection device of FIGURE 4.

### DETAILED DESCRIPTION OF THE DRAWINGS

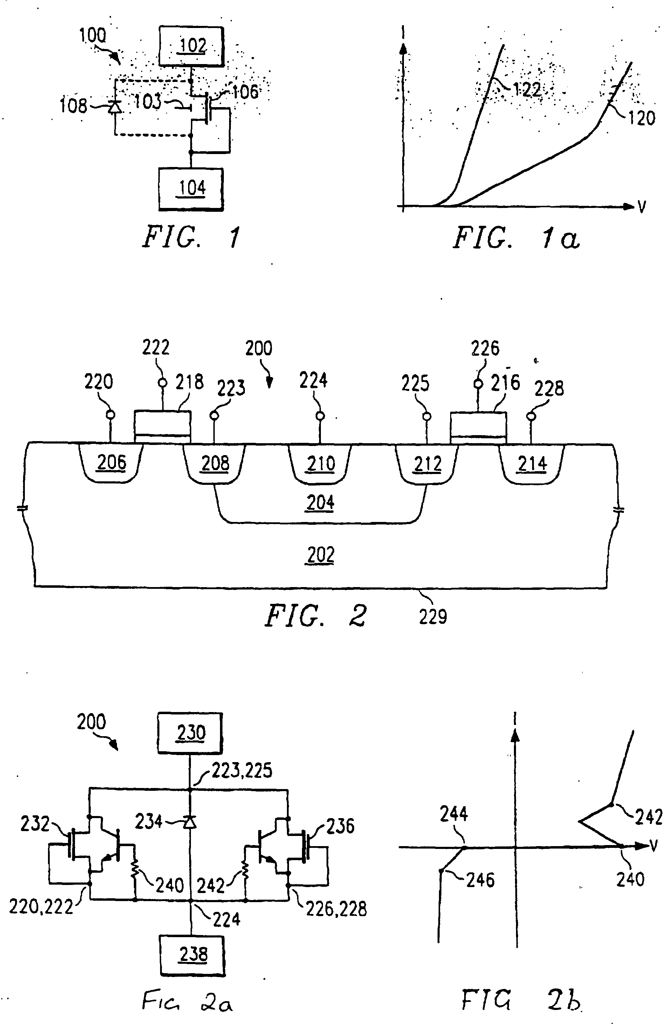

FIGURE 1 illustrates ESD protection circuit 100. ESD protection circuit 100 is comprised of terminals 102 and 104. The circuit which is to be protected by protection circuit 100, which is not illustrated in FIGURE 1, is preferably connected between terminals 102 and 104. Terminals 102 and 104 are supply terminals. Preferably, V_{DD} is applied to terminal 102 while V_{SS} is applied to terminal 104. In a typical ESD event, a positive charge (in reference to ground) is introduced at supply pad 102 while supply pad 104 remains grounded. However, it is also likely that a negative charge or negative voltage (in reference to ground) may collect on supply pad 102 while supply pad 104 is in reference to ground. In the following description, the former event (positive charge on pad 102 in reference to ground) will be referred to as a "positive ESD event" while the latter event (negative charge collected on pad 102 in reference to ground) will be referred to as a "negative ESD event". (Note: A "negative" event on pad 102 is equivalent to a "positive" event on pad 104. This is due to the fact that substrate 103 is floating.) In a positive ESD event, ESD protection circuit 100 is sufficient to protect a circuit connected to ESD protection circuit 100 even if ESD protection circuit does not include reverse diode 108.

However, during a negative ESD event, ESD protection circuit 100 would not provide sufficient ESD protection to circuitry connected to protection circuit 100 if diode 108 is not included in protection circuit 100. Plot 120 of FIGURE 1a illustrates the I-V response of protection circuit 100 during a negative ESD event if diode 108 is not included in protection circuit 100. However, if diode 108 is included in protection circuit 108, circuitry connected to protection circuit 100 would be sufficiently protected. Plot 122 of FIGURE 1a illustrates the I-V response of protection circuit 100 which includes diode 108.

FIGUREs 2 and 2a illustrate ESD protection circuit 200 and its circuit equivalent, respectively. FIGURE 2b illustrates the I-V characteristics of ESD protection circuit 200. Preferably, ESD protection circuit 200 includes two nMOS devices. The first nMOS device is defined by source/drain regions 206 and 208. Preferably, both of these regions are n⁺ regions and source region 206 is connected to conductive gate structure 218 via contacts 220 and 222. In addition, contacts 220 and 222 are connected to ground. The second nMOS device is defined by source/drain regions 212 and 214 and conductive gate structure 216. As with the first nMOS device, source/drain regions 212 and 214 are preferably n⁺ regions and conductive gate structure 216 is connected to source region 214 via contacts 226 and 228. In addition, contacts 226 and 228 are connected to ground.

Lightly doped region 204 is situated between the two nMOS devices, and heavily doped region 210 is situated within region 204. Preferably, lightly doped region is an n- region and heavily doped region 210 is a p⁺ region. Due to the placement of regions 208, 210 and 212, a diode is formed by region 210 and 208 and another diode is formed by regions 210 and 212. Since these two diodes are in parallel, they, as a pair, will have a lower resistance. In addition, one transistor is formed such that its base is formed by the substrate (contacted by backside 229), its emitter is formed from region 206 and the collector is formed by region 208. Similarly, a second transistor is formed by the substrate (base), region 214 (emitter) and region 212 (collector). The circuit diagram for such a device is depicted in FIGURE 2a.

FIGURE 2a represents the circuit equivalent of ESD protection device 200 in FIGURE 2 where specific connections are made. More specifically, the circuit of FIGURE 2a illustrates the device of FIGURE 2 where terminals 220, 222, 224, 226, and 228 are all connected to V_{SS} (represented by block 238, and is preferably grounded) and terminals 223 and 225 are connected to V_{DD} (represented in FIGURE 2a as block 230). In addition, diode 234 represents the diodes formed between region 210 and 208 and regions 210 and 212. Resistors 240 and 242 represent the resistance between the substrate and ground.

FIGURE 2b illustrates the I-V characteristics of protection device 200. During a positive ESD event, nMOS devices 232 and 236 become conductive at point 240. After, "snap-back" and voltage build-up, the diodes (diode 234) go into reverse breakdown and thereby conduct current along with nMOS devices 232 and 236, at point 242. In other words, the nMOS breakdown into a bipolar device occurs before the breakdown of the diodes. Subsequently, the locally generated carriers also trigger the diodes (represented as diode 234) into breakdown and the ESD current is conducted by both the nMOS devices and the diodes.

In a negative ESD event, nMOS devices 232 and 236 become conductive at point 244, and both the nMOS devices and the diodes (diode 234) become conductive at point 246. More specifically, the nMOS devices will first turn on due to sub-threshold conduction and go into saturation. However, with only a small current draw, the diodes will turn on in forward bias mode and protect the nMOS devices from damage. Hence, the nMOS devices are important for positive ESD events because of the "snap-back" effect of these devices which protects the gate oxides of the circuits to be protected and because they trigger the diodes. However, the diodes are the primary protection devices during negative ESD events.

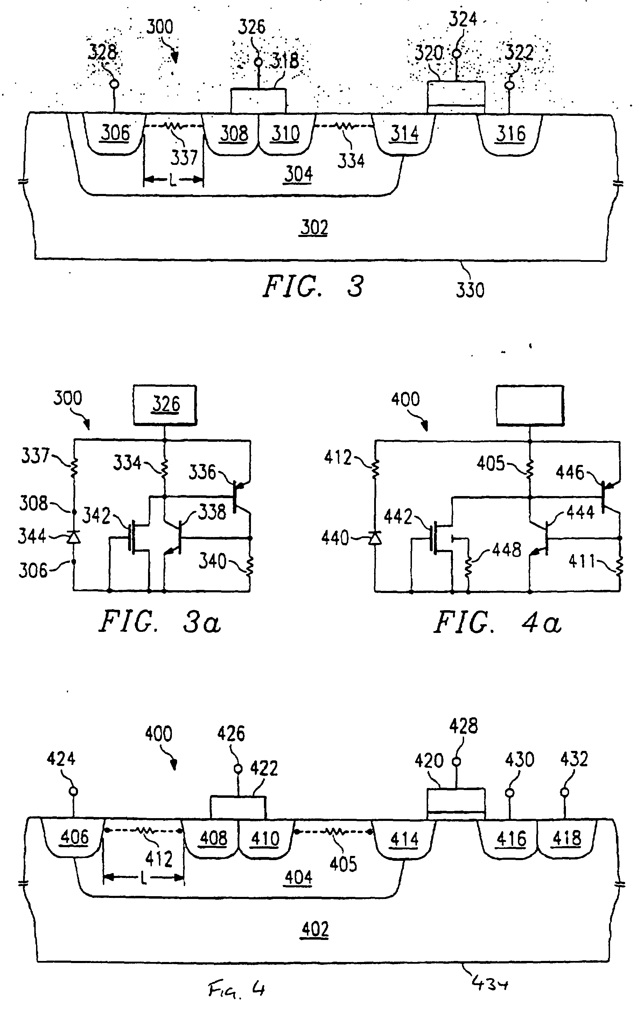

FIGURE 3 illustrates low-voltage SCR (LVTSCR) 300 which is preferably used to protect DRAM circuitry from negative ESD event damage. FIGURE 3a illustrates a circuit equivalent of low-voltage SCR 300. Referring to FIGURE 3, LVTSCR 300 is comprised of an nMOS device which includes gate structure 320 and source/drain regions 314 and 316. Preferably source/drain regions are n⁺ regions and substrate 302 is of a p-type. Source region 316 is connected to gate structure 320 via terminals 322 and 324 and both are preferably connected to ground. Lightly doped region 304 abuts source/drain region 314 and is preferably a n- region. Region 310 may be placed within region 304 such that it abuts region 314 (this is done where these regions are not silicided) or it may be spaced away from region 314 (as is shown in FIGURE 3). No matter whether region 310 abuts region 314 or not, region 310 and region 308 are formed such that they abut. Preferably, region 308 is a heavily doped n-type region (n⁺ region) and region 310 is a heavily doped p-type region (p⁺ region). Both region 308 and 310 are contacted to contact 318 which is connected to terminal 326. Terminal 326 is preferably connected to a supply or it may be an input/output terminal. Region 306 is formed within region 304 such that its distance, L, from region 308 is minimized. Region 306 is preferably a p⁺ region and is preferably connected to ground via terminal 328.

Terminal 326 provides the contact to the anode of the SCR of FIGURE 3, and terminal 322 provides the contact to the cathode of the SCR of FIGURE 3. In addition, terminal 326 provides the contact to the cathode of diode 344, while terminal 328 provides the contact to the anode of diode 344.

FIGURE 3a is an equivalent circuit schematic of the integrated structure of FIGURE 3. The pnp device 336 is formed from regions 310, 304, and 302 while resistor 340 represents the substrate resistance to ground. The npn device 338 is formed by regions 314, 302, and 316 while resistor 334 represents the resistance between regions 310 and 314. The series element of diode 344 and resistor 337 is formed by regions 306 and 308 (forming diode 344) and well region 304 (forming resistor 337).

Even without region 306, LVTSCR 300 forms an effective ESD protection device for grounded substrate integrated chips. For positive stress, the pnpn device, formed with regions 310, 304, 302, and 316 latches to provide adequate protection. For negative stress events where the substrate is grounded, the forward biased diode, formed by regions 304 and 302, provides adequate protection. However, for DRAMs with a floating substrate this diode for negative stress is not present. Therefore, the nMOS device formed by regions 314, 320, and 316 fails for similar reasons that device 100 of FIGURE 1 failed. However, in the protection circuit 300, region 306 (preferably a p⁺ type region) provides lateral diode protection for negative stress. The lateral diode (diode 344) is formed by regions 306 and 308. In other words, lateral diode 344 protects nMOS device 342 (formed by regions 314 and 316 and gate 320) during negative stress. In view of this, protection circuit 300 can be used for DRAM input/output pin protection applications.

FIGURE 4 illustrates ESD protection device 400 which is operable in instances for grounded substrate chips and where a large ESD charge is applied to wafer backside 434. This type of situation may be introduced during a charge device model (CDM) event. In such an event, terminals 424, 428, 430 and 432 are preferably connected to wafer backside 434 while terminal 426 is connected to ground.

ESD protection device 400 includes an nMOS device which is comprised of source/drain regions 414 and 416 (preferably n⁺ regions) and conductive gate structure 420. Region 418 abuts region 416 and provides a contact to substrate 402. Preferably, region 418 is a p⁺ region. Source/drain region 414 abuts lightly doped region 404, which is preferably an n- region formed in a p-type substrate. Heavily doped regions 408 and 410 abut each other and are spaced from source/drain region 414. Preferably region 408 is a n⁺ region and region 410 is a p⁺ region. Region 408 is preferably spaced a minimum distance, L, from region 406 (which is preferably a p⁺ region).

Region 406 abuts region 404 and is preferably placed a minimum distance, L, from region 408. When substrate 402 becomes positively charged and terminal 426 is grounded, diode 440, which is formed by regions 406 and 408, becomes forward biased and protects nMOS device 442, which is formed by regions 414 and 416 and gate 420. Although there is an inherent vertical diode present (formed by substrate 402 and n-well 404 and highly doped region 408), this is not effective to provide the appropriate protection due to the resistance of region 404. Instead, lateral diode 440 carries more of the CDM current flow to protect nMOS device 442 because diode 440 has a relatively lower resistance (denoted as resistor 412). LVTSCR 400 provides effective protection for grounded substrate chips for both CDM and the human body model (HBM).

Terminal 426 provides the contact to the anode of the SCR of FIGURE 4, while terminal 430 provides the contact to the cathode of the SCR of FIGURE 4. In addition, terminal 426 provides the contact to the cathode of diode 440, and terminal 424 provides the contact to the anode of diode 440.

FIGURE 4a is an equivalent circuit schematic of the integrated structure of FIGURE 4. The pnp device 446 is formed from regions 410, 404, and 402, while resistor 411 represents the substrate resistance. The npn device 444 is formed from regions 414, 402, and 416 and resistor 405 represents the resistance between regions 410 and 414. Resistor 448 also represents the substrate resistance.

In summary, protection device 100, which includes diode 108, provides effective power supply protection for DRAMs. Protection device 300 is an effective input/output protection device for DRAMs, and is operable in both HBM and CDM. Protection device 400 is an effective input/output protection device for logic circuitry with a grounded substrate. Protection device 400 is effective for both HBM and CDM.

## Claims

1. An ESD protection circuit for protecting a circuit from negative stress due to an electrostatic discharge, said ESD protection circuit comprising:
a substrate (202) of a first conductivity type and having a surface;
a lightly doped region (204) of a second conductivity type opposite said first conductivity type and situated in said substrate (202);
a first doped region (210) of said first conductivity type and situated at said surface of said substrate (202) and in said lightly doped region (204), said first doped region (210) forming the anode of a first diode and a second diode;
a first source region (206) of said second conductivity type and situated at said surface of said substrate (202) and spaced away from said lightly doped region (204);
a first drain region (208) of said second conductivity type and situated at said surface of said substrate (202), spaced away from said first source region (206) by a first channel region, and abutting said lightly doped region (204), said first drain region forming the cathode of said first diode;
a first gate (218) insulatively disposed over said first channel region, said first source region (206), first drain region (208) and said first gate (218) forming a first transistor;
a second source region (214) of said second conductivity type and situated at said surface of said substrate (202) and spaced away from said lightly doped region (204);
a second drain region (212) of said second conductivity type and situated at said surface of said substrate (202), spaced away from said second source region (214) by a second channel region, and abutting said lightly doped region (204), said second drain region (212) forming the cathode of said second diode;
a second gate (216) insulatively disposed over said second channel region, said second source region (214), second drain region (212) and said second gate (216) forming a second transistor, whereby said lightly doped region (204) is situated between said first and said second transistor;
**characterized in that** said first source region (206), said first gate (218), said second source region (214), said second gate (216), and said first doped region (210) are electrically connected and said first and second drain regions (208, 212) are electrically connected together, so that said first and second diodes protect said first and second transistors and said circuit to be protected during said negative stress due to electrostatic discharge.

## Patentansprüche

1. Eine ESD-Schutzschaltung, um eine Schaltung vor einer negativen Belastung durch eine elektrostatische Entladung zu schützen, wobei die Schutzschaltung gegen elektrostatische Entladung folgendes umfasst:
ein Substrat (202) mit einer ersten Art spezifischer Leitfähigkeit, das eine Oberfläche aufweist;
einen leicht dotierten Bereich (204) mit einer zweiten Art spezifischer Leitfähigkeit gegenüberliegend der ersten Art spezifischer Leitfähigkeit, der sich in dem Substrat (202) befindet;
einen ersten dotierten Bereich (210) mit einer ersten Art spezifischer Leitfähigkeit, der sich an der Oberfläche des Substrats (202) und im leicht dotierten Bereich (204) befindet, wobei der erste dotierte Bereich (210) die Anode einer ersten Diode und einer zweiten Diode bildet;
einen ersten Quellenbereich (206) mit der zweiten Art spezifischer Leitfähigkeit, der sich an der Oberfläche des Substrats (202) befindet und einen Zwischenraum zum leicht dotierten Gebiet (204) hat;
einen ersten Senkenbereich (208) mit der zweiten Art spezifischer Leitfähigkeit, der sich an der Oberfläche des Substrats (202) befindet, durch einen ersten Kanalbereich einen Zwischenraum zum ersten Quellenbereich (206) hat und an den leicht dotierten Bereich (204) angrenzt, wobei der erste Quellenbereich die Kathode der ersten Diode bildet;
ein erstes Tor (218), das über dem ersten Kanalbereich isoliert angebracht ist, wobei der erste Quellenbereich (206), der erste Senkenbereich (208) und das erste Tor (218) einen ersten Transistor bilden;
einen zweiten Quellenbereich (214) mit der zweiten Art spezifischer Leitfähigkeit, der sich an der Oberfläche des Substrats (202) befindet und einen Zwischenraum zum leicht dotierten Gebiet (204) hat;
einen zweiten Senkenbereich (212) mit der zweiten Art spezifischer Leitfähigkeit, der sich an der Oberfläche des Substrats (202) befindet, durch einen zweiten Kanalbereich einen Zwischenraum zum zweiten Quellenbereich (214) hat, und an den leicht dotierten Bereich (204) angrenzt, wobei der zweite Quellenbereich (212) die Kathode der zweiten Diode bildet;
ein zweites Tor (216), das über dem zweiten Kanalbereich isoliert angebracht ist, wobei der zweite Quellenbereich (214), der zweite Senkenbereich (212) und das zweite Tor (216) einen zweiten Transistor bilden, wobei der leicht dotierte Bereich (204) sich zwischen dem ersten und zweiten Transistor befindet;
**dadurch gekennzeichnet, dass** der erste Quellenbereich (206), das erste Tor (218), der zweite Quellenbereich (214), das zweite Tor (216) und der erste dotierte Bereich (210) leitend verbunden sind, und der erste und zweite Senkenbereich (208, 212) derart leitend verbunden sind, dass die erste und die zweite Diode den ersten und zweiten Transistor und die während einer negativen Belastung durch eine elektrostatische Entladung zu schützende Schaltung schützen.

## Revendications

1. Circuit de protection ESD pour protéger un circuit d'une sollicitation négative due à une décharge électrostatique, ledit circuit de protection ESD comprenant :
un substrat (202) d'un premier type de conductivité et ayant une surface ;
une région (204) légèrement dopée d'un deuxième type de conductivité opposé audit premier type de conductivité, et située dans ledit substrat (202) ;
une première région dopée (210) dudit premier type de conductivité et située au niveau de ladite surface dudit substrat (202) et dans ladite région légèrement dopée (204), ladit première région dopée (210) formant l'anode d'une première diode et d'une deuxième diode ;
une première région de source (206) dudit deuxième type de conductivité et située au niveau de ladite surface dudit substrat (202) et espacée de ladite région légèrement dopée (204) ;
une première région de drain (208) dudit deuxième type de conductivité et située au niveau de ladite surface dudit substrat (202), espacée de ladite première région de source (206) par une première région de canal, et venant buter sur ladite région légèrement dopée (204), ladite première région de drain formant la cathode de ladite première diode ;
une première grille (218) disposée de manière isolante sur ladite première région de canal, ladite première région de source (206), ladite première région de drain (208) et ladite première grille (218) formant un premier transistor ;
une deuxième région de source (214) dudit deuxième type de conductivité et située au niveau de ladite surface dudit substrat (202) et espacée de ladite région légèrement dopée (204) ;
une deuxième région de drain (212) dudit deuxième type de conductivité et située au niveau de ladite surface dudit substrat (202), espacée de ladite deuxième région de source (214) par une deuxième région de canal, et venant buter sur ladite région légèrement dopée (204), ladite deuxième région de drain (212) formant la cathode de ladite deuxième diode ;
une deuxième grille (216) disposée de manière isolante sur ladite deuxième région de canal, ladite deuxième région de source (214), une deuxième région de drain (212) et ladite deuxième grille (216) formant un deuxième transistor, à la suite de quoi ladite région légèrement dopée (204) est située entre ledit premier et ledit deuxième transistors ;
**caractérisé en ce que** ladite première région de source (206), ladite première grille (218), ladite deuxième région de source (214), ladite deuxième grille (216), et ladite première région dopée (210), sont connectées électriquement et lesdites première et deuxième régions de drain (208, 212) sont connectées électriquement ensemble, de telle sorte que lesdites première et deuxième diodes protègent lesdits premier et deuxième transistors et ledit circuit à protéger au cours de ladite sollicitation négative due à une décharge électrostatique.
